# EUROPEAN PATENT APPLICATION

(11) **EP 4 156 293 A1**
(43) Date of publication of application: **29.03.2023**
(21) Application number: 22189549.3
(22) Date of filing: 09.08.2022
(51) Int. Cl.: H01L 29/775, H01L 29/08, H01L 21/336, H01L 29/06, H01L 29/16, H01L 29/423, H01L 21/306, H01L 21/20, B82Y 10/00

(54) **TRANSISTORS WITH REDUCED EPITAXIAL SOURCE/DRAIN SPAN VIA ETCH-BACK FOR IMPROVED CELL SCALING**

(30) Priority: 24.09.2021 US 202117485149
(71) Applicant: Intel Corporation, Santa Clara, CA 95054 (US)
(72) Inventor: GHANI, Tahir, Portland, OR 97229 (US); MURTHY, Anand, Portland, OR 97229 (US); PATEL, Pratik, Portland, OR 97229 (US); KEECH, Ryan, Portland, OR 97209 (US); HASAN, Mohammad, Aloha, OR 97006 (US); RAFIQUE, Subrina, Beaverton, OR 97007 (US); GANGULY, Koustav, Beaverton, OR 97006 (US)
(74) Representative: HGF

(57) **Abstract**

Methods, transistors, and systems are discussed related to anisotropically etching back deposited epitaxial source and drain semiconductor materials for reduced lateral source and drain spans in the fabricated transistors. Such lateral width reduction of the source and drain materials enables improved transistor scaling and perturbation reduction in the resultant source and drain semiconductor materials. In particular a nanosheet FET (1000) is disclosed, with nanosheets (108), gate (1001) and epitaxially grown source/drain materials (106, 107). The width of the source/drain regions is larger than the width of the nanosheets, but not more than one-third.

## Description

### BACKGROUND

Transistor cell density is an important characteristic in integrated circuits as increased cell density improves device capability. Due to the ever-increasing demand for higher transistor density, there is a need to reduce the lateral distance between transistors for tighter n-type to p-type (N-P), n-type to n-type (N-N), and p-type to p-type (P-P) transistor spacing. Such increase in transistor density requires reduction in the lateral epitaxial span of the transistor source and drain (EPI S/D). In addition, such spacing reductions need to be achieved using a manufacturable process flow. Ideally, such processes flows do not require barriers or molds to confine epitaxial sources and drains of the scaled down transistors, for example.

It is desirable to increase transistor cell density while providing high quality epitaxial sources and drains in a manufacturable process flow. It is with respect to these and other considerations that the present improvements have been needed. Such improvements may become critical to increase cell density in higher performance integrated circuit electronic devices.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A provides illustrative views of an exemplary transistor structure having reduced width source and drain semiconductors;
FIG. IB provides illustration of a view of the transistor structure of FIG. 1A taken at an interface between exemplary source and drain materials and channel semiconductors;
FIG. 2 illustrates a flow diagram illustrating an example process for fabricating transistor structures having etched-back epitaxial source and drain materials;
FIGS. 3, 4, 5, 6, 7, 8, 9, and 10 illustrate cross-sectional side views of example transistor structures as particular fabrication operations are performed to generate reduced width source and drain semiconductors;
FIG. 11 is an illustrative diagram of a mobile computing platform employing a device having an etched-back epitaxial (Epi) source and/or drain (S/D) transistor; and
FIG. 12 is a functional block diagram of a computing device, all arranged in accordance with at least some implementations of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Transistor structures, device structures, apparatuses, integrated circuits, computing platforms, and methods are described herein related to transistors having reduced epitaxial source and/or drain span for scaled cells. Such transistors have source and/or drain widths that are reduced via etch-back after epitaxial deposition of the source and/or drain.

As discussed, it is desirable to increase transistor cell density while maintaining high quality transistors inclusive of high quality epitaxial sources and drains in a manufacturable process flow. In particular, such increased cell density is attained by reducing epitaxial source and/or drain span (e.g., lateral width) while maintaining source and/or drain height (e.g., vertical height). Thereby, the transistor cell density may be increased as the transistors may be packed more tightly laterally (e.g., perpendicular to a fin direction) while maintaining low contact resistance, high drive current, and other transistor characteristics. Such transistor structures are attained by performing an anisotropic etch-back after epitaxial deposition (or growth) of the source and drain materials. Such etch-back may be performed after the entirety of the source and drain material(s) are deposited or in a multistage approach where a portion of the source and drain material(s) are deposited, a first etch-back is performed, another portion of the source and drain material(s) are deposited, a second etch-back is performed, and so on. Such processing may be performed with any number of etch-backs such as two, three, four, or more. The depositions prior to and between etch-backs may deploy different source and drain materials, the same materials, or the materials may be changed during the between etch-back depositions.

In some embodiments, the techniques discussed herein employ an *in situ* epitaxial deposition and etch-back developed to provide an anisotropic etch that etches the vertical (110) plane (e.g., the sidewall surfaces) of the source and drain semiconductor material at a faster rate than that of the horizontal (001) plane (e.g., the top surface and bottom surface, if exposed). Furthermore, the etch of the semiconductor source and drain material trims the {111} facets of the sidewall surfaces to provide smoother sidewall surfaces. Such etch-back may be performed in the same processing chamber immediately following the deposition (e.g., epitaxial growth of the source and drain materials).

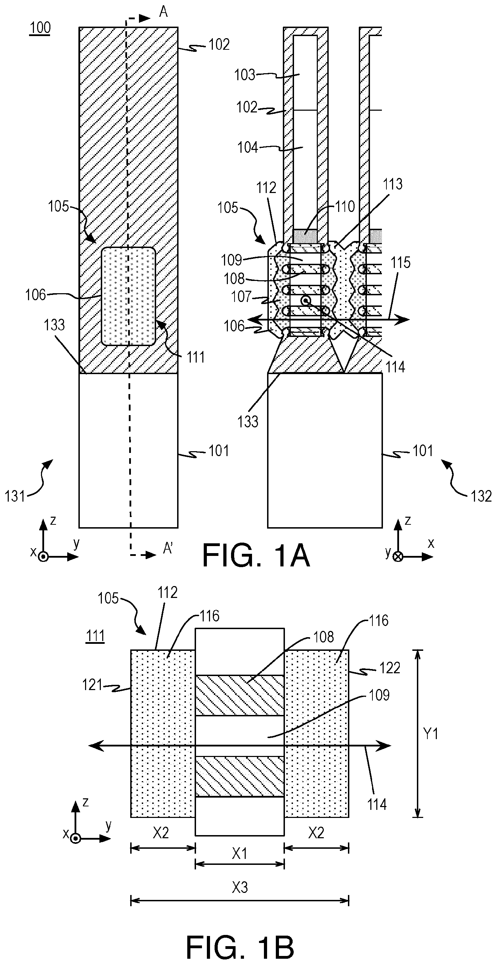

FIG. 1A provides illustrative views of an exemplary transistor structure 100 having reduced width source and drain semiconductors, arranged in accordance with at least some implementations of the present disclosure. FIG. 1A illustrates a first cross-sectional view 131 of transistor structure 100 taken along a fin cut such that a source 112 and an isolation spacer layer 102, which are over substrate 101 are visible. A second cross-sectional view 132 of transistor structure 100 is taken along a gate cut such that channel semiconductors 109, source 112, and drain 113 are visible, along with other components of transistor structure 100 as discussed below. For example, second cross-sectional view 132 provides a view at the A-A' cut through first cross sectional view 131. Furthermore, any number of fin structures (e.g., inclusive of a dummy gate 104, an isolation layer 103, a dummy gate oxide 110, channel semiconductors 109, sacrificial layers 108, and so on) may be provided along the x-axis with shared sources 112 and/or drains 113. The techniques discussed herein provide for reduced spacing along the y-axis of transistor structures 100 as the lateral width of source 112 and drain 113 are reduced.

Transistor structure 100 includes substrate 101, isolation spacer layer 102, isolation layer 103, dummy gate 104, source and drain materials 105 that make up source 112 and drain 113, channel semiconductors 109, sacrificial layers 108, dummy gate oxide 110. As shown, source and drain materials 105 may include a doped epitaxial nucleation layer 107 and a doped epitaxial bulk layer 106. Source and drain materials 105 may further include a capping layer as discussed further herein below.

Substrate 101 may include any suitable material or materials and, in some embodiments, substrate 101 includes a material or materials having the same or a similar composition with respect to channel semiconductors 109. In some embodiments, substrate 101 and channel semiconductors 109 include a Group IV material (e.g., silicon). In some embodiments, substrate 101 and semiconductors 109 include a substantially monocrystalline material. In some embodiments, substrate 101 includes a buried insulator layer (e.g., SiO₂), for example, of a semiconductor-on-insulator (SOI) substrate and or isolation insulator regions and the like. Channel semiconductors 109 may include any number of channel semiconductors, ribbons, or layers over substrate 101 such as three, four, five, or more layers. Channel semiconductors 109 are separated by sacrificial layers 108, which will later be removed and replaced by one or more gate structures inclusive of, for example, gate dielectric materials and gate electrode materials.

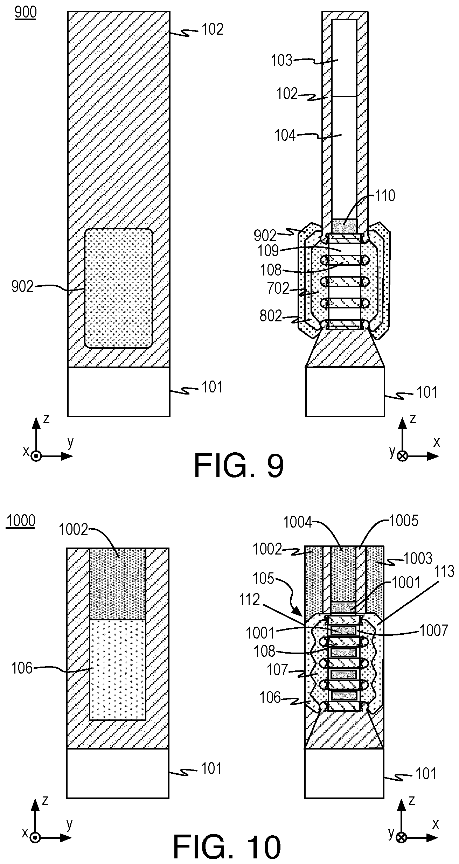

Similarly, dummy gate oxide 110 and dummy gate 104, along with isolation layer 103 may ultimately be removed and replaced with gate dielectric material and gate electrode materials. Notably, FIG. 1A illustrates transistor structure 100 that may be further processed to form a functional device, as discussed herein below. As shown, transistor structure 100 includes source and drain materials 105 inclusive of doped epitaxial nucleation layer 107 and doped epitaxial bulk layer 106. Source and drain materials 105 may also include a doped capping layer on doped epitaxial bulk layer 106 (please refer to FIG. 9). Source and drain materials 105 are epitaxial to channel semiconductors 109 such that they are epitaxially deposited on or grown from channel semiconductors 109 and have a crystallinity epitaxial to channel semiconductors 109. For example, source and drain materials 105 and channel semiconductors 109 may share a crystal lattice structure due to source and drain materials 105 being epitaxially grown from channel semiconductors 109.

As discussed, source and drain materials 105 may include a single layer, a bilayer (as shown in FIG. 1A) or a trilayer (as shown in FIG. 9) or additional layers of doped semiconductor material to couple to channel semiconductors 109. In some embodiments, source and drain materials 105 include a bilayer of doped epitaxial nucleation layer 107 and doped epitaxial bulk layer 106. Such layers may also be characterized simply as doped epitaxial materials or material layers. In some embodiments, doped epitaxial nucleation layer 107 and doped epitaxial bulk layer 106 are both phosphorous and/or arsenic doped silicon (e.g., (P,As):Si N-Epi). In some embodiments, doped epitaxial nucleation layer 107 is doped silicon with a [P] and [As] concentration in the range of 1E19 to 1E21 cm⁻³. As discussed one or both of phosphorous and arsenic may be used with employment of both being advantageous in some contexts. In some embodiments, doped epitaxial bulk layer 106 is doped silicon with a [P] and [As] concentration in the range of 1E21 to 5E21 cm⁻³. In some embodiments, doped epitaxial bulk layer 106 is doped silicon with a [P] and [As] concentration in the range of 3E21 to 5E21 cm⁻³ (e.g., with a concentration exceeding 5E21 cm⁻³).

In some embodiments, source and drain materials 105 include a trilayer of doped epitaxial nucleation layer 107, doped epitaxial bulk layer 106, and a doped epitaxial capping layer on doped epitaxial bulk layer 106. In some embodiments, as with bilayer examples, doped epitaxial nucleation layer 107 and doped epitaxial bulk layer 106 are both phosphorous and/or arsenic doped silicon (e.g., (P,As):Si N-Epi). In some embodiments, doped epitaxial nucleation layer 107 is doped silicon with a [P] and [As] concentration in the range of 1E19 to 1E21 cm⁻³ and doped epitaxial bulk layer 106 is doped silicon with a [P] and [As] concentration in the range of 1E21 to 5E21 cm⁻³, with a concentration in the range of 3E21 to 5E21 cm⁻³ being advantageous in some contexts. In some embodiments, the doped epitaxial capping layer is silicon doped only with phosphorous (e.g., absent arsenic) at a concentration of not less than 3E21 cm⁻³. In some embodiments, the doped epitaxial capping layer is silicon doped only with phosphorous (e.g., absent arsenic) at a concentration of about 5E21 cm⁻³ (e.g., within 10% of 5E21 cm⁻³).

In some embodiments, a single layer of doped epitaxial source and drain material is used. For example, a single layer may include silicon doped with [P] and [As] at a concentration in the range of 1E19 to 1E21 cm⁻³. In some embodiments, the discussed layers of source and drain materials 105 are not discrete layers or bands but instead a gradient approach is deployed. In such contexts, the discussed layers may be evident as sampling layers or regions moving away from channel semiconductor in source and drain materials 105. For example, the discussed concentrations may be found within regions or portions of source and drain materials 105 as represented by the illustrated layers. In some embodiments, source and drain materials 105 include doped epitaxial nucleation layer 107 (or a corresponding portion or region) on or adjacent to channel semiconductors 109 and doped epitaxial bulk layer 106 (or a corresponding portion or region) on or adjacent to doped epitaxial nucleation layer 107 such that the doped epitaxial nucleation layer region or portion has a lower dopant concentration than a region or portion of the doped epitaxial bulk layer. For example, the dopant concentration (e.g., of [P] or [As] or both) may decrease in source and drain materials 105 moving in the positive or negative x-direction towards channel semiconductors 109.

FIG. IB provides illustration of a view 111 of transistor structure 100 taken at an interface between source and drain materials 105 and channel semiconductors 109, arranged in accordance with at least some implementations of the present disclosure. In the illustration of FIG. 1B, source and drain materials 105 are illustrated as a single material for the sake of clarity of presentation. As shown, view 111 is taken along a lateral dimension or axis 114 that is aligned with the y-axis. Notably, lateral axis 114 is substantially perpendicular to a dimension or axis 115 that extends between source 112 and drain 113 along channel semiconductors 109 and aligned with the x-axis (please refer to FIG. 1A). For example, axis 115 may be along a current flow of transistor structure 100 when in operation and may be along a defined channel length of transistor structure 100. Notably, lateral axis 114 is substantially perpendicular to axis 115 and parallel to a surface 133 of substrate 101. Lateral axis is also perpendicular to a build up direction of transistor structure 100 with the build up direction being defined along the z-axis. Such surface 133 is substantially parallel to the x-y plane established herein and the build up direction is substantially perpendicular to the x-y plane.

Techniques discussed herein below describe an anisotropic etch-back and/or trim of deposited source and drain materials such that the etch-back provides for source and drain materials 105 illustrated with respect to FIGS. 1A and 1B as well as other source and drain materials examples illustrated herein. Notably, the anisotropic etch-back reduces a lateral width of the deposited source and drain materials as well as reducing perturbations along vertical sidewalls while providing minimal or no etch-back of the vertical height of the deposited source and drain materials. Such techniques may provide one or more of an increased aspect ratio of source and drain materials 105 (e.g., a greater height to width ratio), reduced dimensional differences in the widths of source and drain materials 105, and a reduced wingspan of source and drain materials 105. Notably, the wingspan of source and drain materials 105 may be defined as the lateral width of source and drain materials 105 as measured relative to the lateral width of channel semiconductor 109 such that the lateral widths are taken along lateral axis 114 as defined above.

For example, as discussed, transistor structure 100 (and other transistor structures discussed herein) include channel semiconductor 109 over substrate 101 and between source 112 and drain 113 such that source 112 and drain 113 are epitaxial to channel semiconductor 109. As shown, channel semiconductor 109 has a lateral width X1. The term lateral width as defined herein is along a lateral dimensional substantially perpendicular to axis 115, which extends between the source and drain of a transistor with the term lateral also indicating axis 115 is substantially parallel to surface 133, the x-y plane, and the established build up planarity (e.g., a plane perpendicular to the build up direction along the z-axis). Lateral width XI may be any suitable dimension such as a lateral width in the range of 10 to 50 nm. The lateral width X1 may be shared by sacrificial layers 108 and, ultimately, by a gate structure that replaces sacrificial layers 108. The lateral width X1 and other measurements discussed herein maybe taken using any suitable techniques such as a single measurement (e.g., at a vertical midpoint of a single channel semiconductor 109) or as an average of several measurements (e.g., at several points along a single channel semiconductor 109, at a single point of several or all channel semiconductors 109, or at several points along several or all channel semiconductors 109).

As shown, source 112 and/or drain 113 has a lateral width X3 such that lateral width is defined in the same manner as discussed above. Furthermore, source 112 and/or drain 113 include portions 116 that extend beyond the lateral width X1 of channel semiconductors 109. Such portions 116 may be defined as wing portions or the like. One or both of portions 116 have a lateral width X2 such that lateral width X2 defines a dimension by which source 112 and/or drain 113 extend beyond the lateral width of channel semiconductor 109. Such lateral width X3 may be defined using vertical sidewall surfaces 121, 122, for example and lateral widths X2 may then be defined as half the difference between lateral width X3 and lateral width X1 (e.g., (X3-X1)/2) or as the measurement from either of vertical sidewall surfaces 121, 122 to channel semiconductor 109. Lateral width X3 may be any suitable dimension such as a lateral width in the range of 20 to 60 nm. In some embodiments, lateral width X3 is in the range of 30 to 50 nm. In some embodiments, lateral width X3 is in the range of 30 to 40 nm. In some embodiments, lateral width X3 is in the range of 20 to 30 nm.

As discussed, source 112 and/or drain 113 have a reduced lateral width for the increase in cell density of transistor structure 100. In some embodiments, the wingspan (or lateral span or, simply span) may be defined as a ratio of lateral width X2 to lateral width X1 (e.g., X2/X1), which may be characterized as a ratio of the lateral width of the source and/or drain extending beyond the channel semiconductor 109 to the lateral width of the channel semiconductor 109. Such a parameter may be characterized as a wingspan ratio herein. In some embodiments, without the etch-back discussed below, the wingspan ratio is about 60%, which is disadvantageous for transistor cell scaling along lateral axis 114. In contrast, transistor structure 100 has a greatly reduced wingspan ratio. In some embodiments, the wingspan ratio (e.g., X2/X1) of transistor structure 100 is not more than one-half. In some embodiments, the wingspan ratio (e.g., X2/X1) of transistor structure 100 is not more than one-third. In some embodiments, the wingspan ratio (e.g., X2/X1) of transistor structure 100 is not more than one-fourth. In some embodiments, the wingspan ratio (e.g., X2/X1) of transistor structure 100 is not more than one-fifth. In some embodiments, the wingspan ratio (e.g., X2/X1) of transistor structure 100 is in the range of 0.15 to 0.5 (e.g., 20% to 50%). In some embodiments, the wingspan ratio (e.g., X2/X1) of transistor structure 100 is in the range of 0.15 to 0.35. In some embodiments, the wingspan ratio (e.g., X2/X1) of transistor structure 100 is in the range of 0.15 to 0.25. Other wingspan ratios less than about 50-60% may be deployed.

In addition or in the alternative, source 112 and/or drain 113 may have an increased aspect ratio relative to source and drain materials 105 deposited without the anisotropic etch-back discussed herein. In some embodiments, a vertical height Y1 (e.g., taken along the z-axis) of source 112 and/or drain 113 may be defined or measured as discussed above with respect to lateral widths XI, X2, X3. In some embodiments, a ratio of vertical height Y1 to lateral width X3 of source 112 and/or drain 113 is not less than 2. In some embodiments, a ratio of vertical height Y1 to lateral width X3 of source 112 and/or drain 113 is not less than 2.1. In some embodiments, a ratio of vertical height Y1 to lateral width X3 of source 112 and/or drain 113 is not less than 2.25. Other aspect ratios of source 112 and/or drain 113 not less than 2.0 may be used.

Also, in addition or in the alternative, source 112 and/or drain 113 may have decreased variability in lateral width X3 along the z-dimension due to facets formed during epitaxial growth being smoothed during etch-back. For example, perturbations that would otherwise be evident along sidewall surfaces 121, 122 may be removed during such etch-back processing. In some embodiments, any measurement of lateral width X3 between sidewall surface 121 and sidewall surface 122 (e.g., a measurement along lateral dimension or axis 114) does not differ by not more than 12 nm. In some embodiments, any measurement of lateral width X3 between sidewall surface 121 and sidewall surface 122 does not differ by not more than 10 nm. In some embodiments, any measurement of lateral width X3 between sidewall surface 121 and sidewall surface 122 does not differ by not more than 8 nm. In some embodiments, any measurement of lateral width X3 between sidewall surface 121 and sidewall surface 122 does not differ by not more than 5 nm. Other measurements of variability may also be deployed. In some embodiments, a variance of not fewer than 5 measurements of lateral width X3 between sidewall surface 121 and sidewall surface 122 is not more than 20% of the average of the lateral width X3 measurements. In some embodiments, a variance of not fewer than 5 measurements of lateral width X3 between sidewall surface 121 and sidewall surface 122 is not more than 15% of the average of the lateral width X3 measurements. In some embodiments, a variance of not fewer than 5 measurements of lateral width X3 between sidewall surface 121 and sidewall surface 122 is not more than 10% of the average of the lateral width X3 measurements.

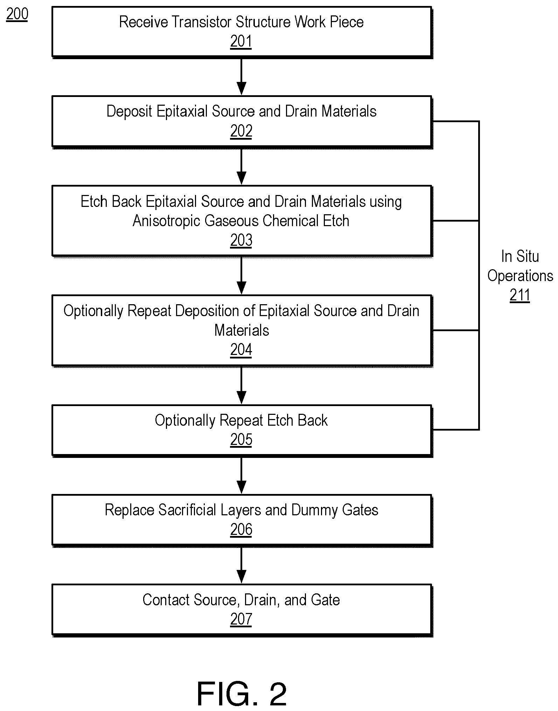

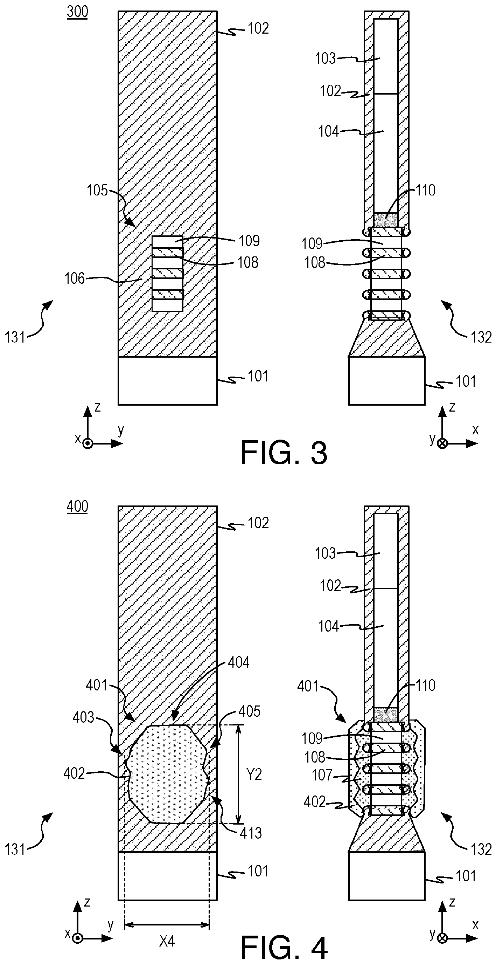

FIG. 2 illustrates a flow diagram illustrating an example process 200 for fabricating transistor structures having etched-back epitaxial source and drain materials, arranged in accordance with at least some implementations of the present disclosure. For example, process 200 may be implemented to fabricate transistor structure 100 or any other transistor structure discussed herein. In the illustrated embodiment, process 200 includes one or more operations as illustrated by operations 201-207. However, embodiments herein may include additional operations, certain operations being omitted, or operations being performed out of the order provided. In an embodiment, process 200 may fabricate transistor structure 100 or a similar transistor structure having a differing etch-back epitaxial source and drain as discussed further herein with respect to FIGS. 3-10.

FIGS. 3, 4, 5, 6, 7, 8, 9, and 10 illustrate cross-sectional side views of example transistor structures as particular fabrication operations are performed to generate reduced width source and drain semiconductors, arranged in accordance with at least some implementations of the present disclosure. In particular, reference will be made to FIGS. 3, 4, 5, 6, 7, 8, 9, and 10 in the context of process 200.

Process 200 begins at operation 201, where a transistor structure work piece is received for processing. For example, NMOS and/or PMOS transistor structures may be formed within, on, and/or over a substrate. The substrate may include any suitable substrate such as a silicon wafer or the like. The NMOS and PMOS transistor structures may be planar, multi-gate, or gate all around transistor structures formed using techniques known in the art. In gate all around examples, a multi-layer structure including alternating layers of channel semiconductor and sacrificial material layers may be deposited and patterned. Sidewall structures and sacrificial gate structures (e.g., inclusive of sacrificial gate oxide, a sacrificial or dummy gate, and an isolation layer) may then be formed as known in the art.

Referring now to FIG. 3, an example received transistor structure 300 (e.g., transistor structure work piece) includes substrate 101, isolation spacer layer 102 (including portions on sacrificial layers 108 and optional portions between substrate 101 and the remainder of the structure), isolation layer 103, dummy gate 104, dummy gate oxide 110, sacrificial layers 108 and channel semiconductors 109. Transistor structure 300 may be fabricated using any suitable technique or techniques. As shown in both of cross-sectional views 131, 132, portions of channel semiconductors 109 are exposed for growth of epitaxial source and drain materials.

Returning to FIG. 2, processing continues at operation 202, where epitaxial source and drain materials are deposited via growth from the exposed portions of the channel semiconductors. The epitaxial source and drain materials may be deposited using any suitable technique or techniques such as chemical vapor deposition including dopant materials. As shown with respect to *in situ* operations 211, operations 202-205 may be performed in the same processing chamber sequentially such that, for example, a processing work piece (e.g., wafer) is not removed from the chamber during such operations. Furthermore, operations 211 illustrate that deposition and etch-back may be performed once each (e.g., operation 202 followed by operation 203, then continuing directly to operation 206) or multiple times each (e.g., operation 202 followed by operation 203, then operation 204 followed by operation 205, then any number of repeats of such operations before continuing to operation 206).

In some embodiments, operation 202 includes deposition of one, two, three, or more layers of doped epitaxial source and drain materials prior to etch-back. In some embodiments, two layers are deposited or grown: a doped epitaxial nucleation layer and a doped epitaxial bulk layer 106, which is described with respect to FIG. 4. For example, the doped epitaxial nucleation layer may be formed on the channel semiconductor and the doped epitaxial bulk layer may be formed on the doped epitaxial nucleation layer such that the doped epitaxial bulk layer has a greater dopant concentration than the doped epitaxial nucleation layer.

In some embodiments, three layers are deposited or grown: a doped epitaxial nucleation layer, a doped epitaxial bulk layer, and a doped epitaxial capping layer. For example, the doped epitaxial nucleation layer may be formed on the channel semiconductor, the doped epitaxial bulk layer may be formed on the doped epitaxial nucleation layer such that the doped epitaxial bulk layer has a greater dopant concentration than the doped epitaxial nucleation layer, and the doped epitaxial capping layer may be formed on the doped epitaxial bulk layer such that the doped epitaxial capping layer has only a phosphorous dopant concentration.

FIG. 4 illustrates an example transistor structure 400 similar to transistor structure 300 after the epitaxial growth of source and drain materials 401, arranged in accordance with at least some implementations of the present disclosure. As shown, source and drain materials 401 include doped epitaxial nucleation layer 107 and a doped epitaxial bulk layer 402 having perturbations such that source and drain materials 401 have relatively nonuniform outer surfaces. In particular, source and drain materials 401, as discussed, are a doped epitaxial semiconductor such phosphorous and arsenic doped silicon having a top surface 404 (and bottom surface, not labeled) along a crystalline (001) plane, side surfaces 403, 413 along a crystalline (110) plane and having {111} facets 405 at intersections of the crystalline planes. For example, facets form at an angle of about 55° between the (111) plane and (001) plane and at an angle of about 35° between the (111) plane and the (110) plane). Also as shown, source and drain materials 401 have a largest lateral width X4 and a largest lateral height Y2.

Returning to FIG. 2, processing continues at operation 203, where the deposited or grown epitaxial materials are etched-back using an anisotropic gaseous chemical etch. Notably, the deployed gaseous chemical etch chemistry provides for anisotropy such that vertical surfaces (e.g., the crystalline (110) plane) are etched at a much faster rate than horizontal surfaces (e.g., the crystalline (001) plane). Thereby, the width of the deposited epitaxial materials is reduced at a much greater rate than the height. Furthermore, facets (e.g., {111} facets) are etched at a greater rate to smooth out such facets particularly along the vertical sidewalls. For example, the facets are high energy etch points or locations that etch more quickly than even the crystalline (110) plane. As discussed, operation 203 may be performed *in situ* with respect to operation 202.

To achieve such anisotropic etch characteristics of the [P] and/or [As] doped epitaxial silicon, an etch chemistry including hydrochloric acid (HCl) and one or more of silane, phosphane, and germane is deployed at an elevated temperature such as a temperature in the range of 500 to 800°C. In some embodiments, the etch is performed at a temperature of not less than 700°C. Notably, chlorine is a necessary etchant, which may be advantageously deployed as gaseous HCl, while silane, phosphane, and germane may be used in any combination. In some embodiments, all three of silane, phosphane, and germane are deployed. In some embodiments, when germane is deployed either alone or in combination with one or both of silane and phosphane, the temperature may be reduced as germane acts as a catalyst that reduces the etch rate. In some embodiments, when germane is deployed, the etch temperature is in the range of 500 to 650°C.

As discussed, any combination of silane, phosphane, and germane may be used with gaseous HCl. In some embodiments, the gaseous chemical etch is performed using HCl and silane absent phosphane and germane. In some embodiments, the gaseous chemical etch is performed using HCl and phosphane absent silane and germane. In some embodiments, the gaseous chemical etch is performed using HCl and silane and phosphane absent germane. For example, such etching may be performed at a temperature in the range of 600 to 800°C such as a temperature in the range of 650 to 750°C. In some embodiments, the gaseous chemical etch is performed using HCl and germane absent phosphane and silane. In some embodiments, the gaseous chemical etch is performed using HCl and germane including one of phosphane and silane. For example, such etching may be performed at a temperature in the range of 500 to 650°C such as a temperature in the range of 600 to 650°C.

Furthermore, in the use of any combination of silane, phosphane, and germane with HCl, flow rates may be controlled to achieve and/or enhance the desired anisotropy. In some embodiments, the ratio of the flow rate of HCl to that of the hydrides (e.g., one or more of silane, phosphane, and germane) is in the range of 1 to 10. Notably, a flow rate ratio of HCl to hydrides of not more than 10 may achieve the desired anisotropy and facet etch to achieve highly uniform and nearly cuboid source and drain semiconductors. Furthermore, it is noted that such gaseous chemical etch may be performed at low or high temperature while maintaining the desired anisotropy and facet etch characteristics.

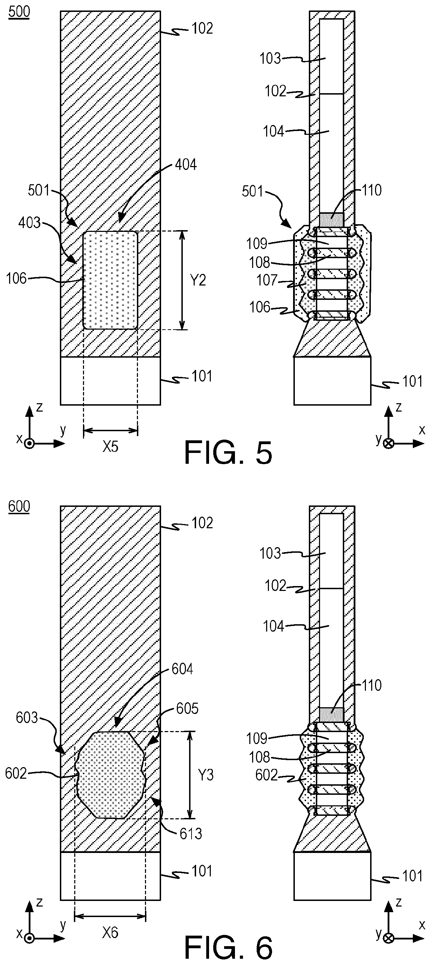

FIG. 5 illustrates an example transistor structure 500 similar to transistor structure 400 after the etch-back of epitaxially grown source and drain materials 401, arranged in accordance with at least some implementations of the present disclosure. As shown, source and drain materials 401 are etched-back to provide source and drain materials 501 inclusive of doped epitaxial nucleation layer 107 and doped epitaxial bulk layer 106. Notably, transistor structure 500 may have any characteristics discussed with respect to transistor structure 100. As discussed, anisotropic etch of source and drain materials 401 is achieved via use of chlorine (e.g., deployed as gaseous HCl) and one or more of silane, phosphane, and germane in a gaseous chemical etch at a temperature in a range of 600 to 800°C using, for example, flow rates as discussed herein.

As shown, source and drain materials 501 have a reduced lateral width X5 relative to lateral width X4 of source and drain materials 401 while having a vertical height Y2 that is substantially the same as the vertical height Y2 of source and drain materials 401 (refer to FIG. 4) due the anisotropy of the gaseous chemical etch. Furthermore, faceting and other perturbations of source and drain materials 401 have been substantially removed in the formation of source and drain materials 501.

Returning to FIG. 2, as discussed, in some examples, a single deposition (e.g., at operation 202) followed by a single etch-back deposition (e.g., at operation 203) may be used. In such embodiments, operations 204, 205 may be bypassed. In other examples, repeated deposition/etch cycles may be performed as shown with respect to optional deposition operation 204 and optional etch-back operation 205. Notably, operations 204, 205 may be performed using any techniques discussed with respect to operations 202, 203. In some embodiments, an epitaxial material deposition grows a single material dopant concentration, an etch-back is performed, and a second material deposition grows another material dopant concentration, followed by an optional etch-back, optionally followed by a third material deposition, followed by another optional etch-back.

For example, it may be advantageous to perform an etch-back after a doped epitaxial nucleation layer deposition. For example, the doped epitaxial nucleation layer deposition may be highly non-conformal and the etch-back may provide a conformal material layer such that subsequent doped epitaxial layers may not need to be etched-back.

FIG. 6 illustrates an example transistor structure 600 similar to transistor structure 300 after the epitaxial growth of a doped epitaxial nucleation layer 602, arranged in accordance with at least some implementations of the present disclosure. As shown, doped epitaxial nucleation layer 602 may form in a highly non-conformal manner epitaxial to channel semiconductor 109. Doped epitaxial nucleation layer 602 may have any characteristics discussed herein with respect to doped epitaxial nucleation layer 107. For example, doped epitaxial nucleation layer 602 may be silicon doped with one or both of phosphorous and arsenic at a concentration in the range of 1E19 to 1E21 cm⁻³ such as a concentration of 5E20 cm⁻³. Furthermore, doped epitaxial nucleation layer 602 may have a lower dopant concentration than a subsequently formed doped epitaxial bulk layer.

Similar to source and drain materials 401, doped epitaxial nucleation layer 602 are a doped epitaxial semiconductor such phosphorous and arsenic doped silicon having a top surface 604 (and bottom surface, not labeled) along a crystalline (001) plane, side surfaces 603, 613 along a crystalline (110) plane and having {111} facets 605 at intersections of a (111) plane and the crystalline (110) plane. Also as shown, doped epitaxial nucleation layer 602 has a largest lateral width X6 and a largest lateral height Y3.

As discussed with respect to process 200, the deposited or grown doped epitaxial nucleation layer is then etched-back using an anisotropic gaseous chemical etch such that an anisotropy is provided. The anisotropic etch etches vertical surfaces (e.g., sidewall surfaces) at a much faster rate than horizontal surfaces (e.g., top and bottom surfaces) such that the width of the resultant doped epitaxial nucleation layer is reduced at a much greater rate than the height. Furthermore, facets (e.g., {111} facets) are etched at a greater rate such that they are smoothed out.

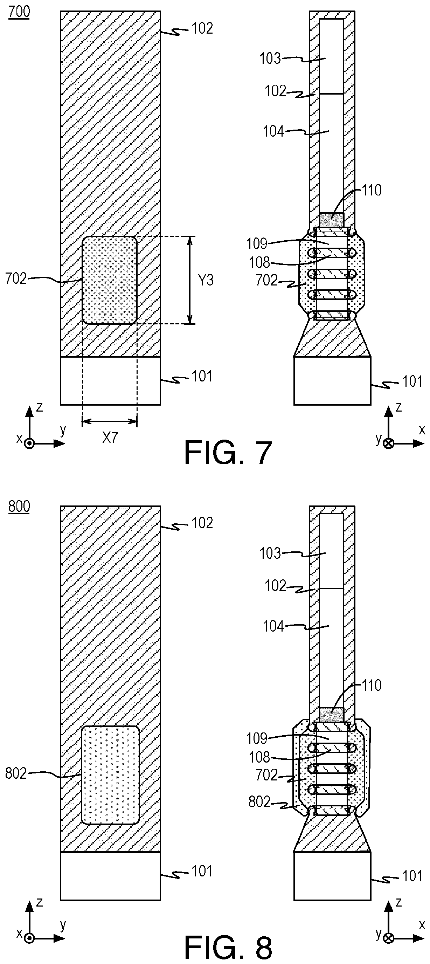

FIG. 7 illustrates an example transistor structure 700 similar to transistor structure 600 after the etch-back of doped epitaxial nucleation layer 602, arranged in accordance with at least some implementations of the present disclosure. As shown, doped epitaxial nucleation layer 602 is etched-back to provide doped epitaxial nucleation layer 702 such that doped epitaxial nucleation layer 702 has a greater aspect ratio relative to doped epitaxial nucleation layer 602, smoother sidewalls, and a more cuboid structure. Notably, doped epitaxial nucleation layer 702 may provide a conformal layer for growth of a subsequent doped epitaxial bulk layer. Furthermore, the anisotropic etch of doped epitaxial nucleation layer 602 is achieved via use of chlorine (e.g., deployed as gaseous HCl) and one or more of silane, phosphane, and germane in a gaseous chemical etch at a temperature in a range of 600 to 800°C using, for example, flow rates as discussed herein. The anisotropic etch of doped epitaxial nucleation layer 602 may be performed using any such gaseous chemical etch techniques.

As shown, doped epitaxial nucleation layer 702 has a reduced lateral width X7 relative to lateral width X6 of doped epitaxial nucleation layer 602 while having a vertical height Y3 that is substantially the same as the vertical height Y3 of doped epitaxial nucleation layer 702 (refer to FIG. 6) due the anisotropy of the gaseous chemical etch. Furthermore, faceting and other perturbations of doped epitaxial nucleation layer 602 have been substantially removed.

As discussed with respect to process 200, a second epitaxial growth or deposition may then be performed using any suitable technique or techniques discussed with respect to operation 202.

FIG. 8 illustrates an example transistor structure 800 similar to transistor structure 700 after the epitaxial growth of a doped epitaxial bulk layer 802, arranged in accordance with at least some implementations of the present disclosure. As shown, doped epitaxial bulk layer 802, due to the refinement of doped epitaxial nucleation layer 702 may form in a highly conformal manner to provide a substantially cuboid material. Doped epitaxial bulk layer 802 may have any characteristics discussed herein with respect to doped epitaxial bulk layer 106. For example, epitaxial bulk layer 802 may have a higher dopant concentration compared to the doped epitaxial nucleation layer 702. In some embodiments, doped epitaxial bulk layer 802 may be etched-back as discussed herein to provide a greater aspect ratio, smaller span, and/or to remove perturbations that arise from the deposition of doped epitaxial bulk layer 802.

As discussed herein, a trilayer of doped epitaxial source and drain materials may be deployed. Such materials may be deposited without etch-back therebetween or with etch-back between any of such deposited materials. Furthermore, additional doped epitaxial source and drain material layers may be used.

FIG. 9 illustrates an example transistor structure 900 similar to transistor structure 800 after the epitaxial growth of a doped epitaxial capping layer 902, arranged in accordance with at least some implementations of the present disclosure. Doped epitaxial capping layer 902 is illustrated as being deposited over doped epitaxial bulk layer 802 and doped epitaxial nucleation layer 702, however doped epitaxial capping layer 902 may be deposited over any suitable material layers. In some embodiments, doped epitaxial capping layer 902 is deposited over doped epitaxial bulk layer 106 of FIG. 5. An optional etch-back may then be performed. In some embodiments, doped epitaxial capping layer 902 is deposited over doped epitaxial bulk layer 402 of FIG. 4 and an etch-back of the epitaxial capping layer is then performed. In any event, the resultant source and drain semiconductor material may include an epitaxial capping layer on the epitaxial bulk layer, which may, in turn, be on an epitaxial nucleation layer.

As shown, in some embodiments, doped epitaxial capping layer 902, due to the refinement of doped epitaxial nucleation layer 702 and/or refinement of doped epitaxial bulk layer 802, may form in a highly conformal manner to provide a substantially cuboid material. In some embodiments, doped epitaxial capping layer 902 is silicon doped with only phosphorus (e.g., at a concentration exceeding 3E21 cm⁻³ such as a concentration of about 5E21 cm⁻³). In some embodiments, doped epitaxial capping layer 902 may be etched-back as discussed herein to provide a greater aspect ratio, smaller span, and/or to remove perturbations.

Returning to FIG. 2, after such single deposit/etch or multiple cyclic deposit/etch processing, processing continues at operation 206, where the sacrificial layers adjacent the channel semiconductor the dummy gate materials may be replaced with gate structures using any suitable technique or techniques known in the art. For example, the sacrificial layers may be selectively etched and the requisite structures may be formed via deposition and optional patterning techniques. Processing continues at operation 207, where the source and drain semiconductor and gate structures are contacted via metal contacts using any suitable technique or techniques such as patterning and metal deposition processing as is known in the art.

FIG. 10 illustrates an example transistor structure 1000 similar to transistor structure 500 after the formation of gate structures and source, drain, and gate contacts, arranged in accordance with at least some implementations of the present disclosure. In the example of FIG. 10, the source and drain material structures of transistor structure 500 are used for exemplary purposes. However, any such source and drain material structures may be used such as those of transistor structure 800, transistor structure 900, or any other source and drain material structures discussed herein. As shown, sacrificial layers 108, dummy gate oxide 110, dummy gate 104, and isolation layer 103 are removed and are, at least in part, replaced by gate dielectric 1007, gate electrode 1001, source contact 1002, drain contact 1003, gate contact 1004, and spacer 1005 (which may include some or all of isolation spacer layer 102). Such processing may be performed using operations known in the art. Furthermore, such components may include any suitable materials. for example, gate dielectric 1007 may be a high-k material such as hafnium oxide, gate electrode 1001 may include a work function material such as a metal and source contact 1002, drain contact 1003, gate contact 1004 may include contact metals.

Notably, transistor structure 1000 includes channel semiconductor 109 over substrate 101 and between source 112 and drain 113, which are epitaxial to channel semiconductor 109. Furthermore, as discussed herein with respect to FIG. 1B, channel semiconductor 109 has a lateral width X1 along a lateral dimensional (e.g., the y axis) substantially perpendicular to an axis extending between source 112 and drain 113, source 112 and/and drain 113 have a portion that extends beyond the lateral width of channel semiconductor 109 along the dimension by a lateral width X2 such that lateral width X2 is not more than, for example, one-third of lateral width X1. Transistor structure 1000 further includes gate electrode 1001 coupled to channel semiconductor 109 and source contact 1002 coupled to source 112 and drain contact 10003 coupled to drain 113.

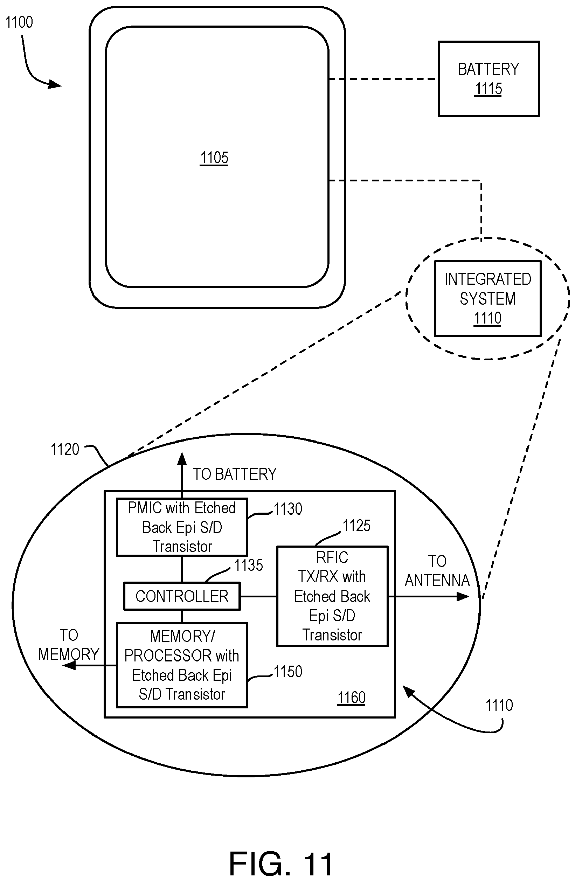

FIG. 11 is an illustrative diagram of a mobile computing platform 1100 employing a device having an etched-back epitaxial (Epi) source and/or drain (S/D) transistor, arranged in accordance with at least some implementations of the present disclosure. Any die or device having a transistor structure inclusive of any components, materials, or characteristics discussed herein may be implemented by any component of mobile computing platform 1100. Mobile computing platform 1100 may be any portable device configured for each of electronic data display, electronic data processing, wireless electronic data transmission, or the like. For example, mobile computing platform 1100 may be any of a tablet, a smart phone, a netbook, a laptop computer, etc. and may include a display screen 1105, which in the exemplary embodiment is a touchscreen (e.g., capacitive, inductive, resistive, etc. touchscreen), a chip-level (system on chip - SoC) or package-level integrated system 1110, and a battery 1115. Battery 1115 may include any suitable device for providing electrical power such as a device consisting of one or more electrochemical cells and electrodes to couple to an outside device. Mobile computing platform 1100 may further include a power supply to convert a source power from a source voltage to one or more voltages employed by other devices of mobile computing platform 1100.

Integrated system 1110 is further illustrated in the expanded view 1120. In the exemplary embodiment, packaged device 1150 (labeled "Memory/Processor" in FIG. 11) includes at least one memory chip (e.g., RAM), and/or at least one processor chip (e.g., a microprocessor, a multi-core microprocessor, or graphics processor, or the like). In an embodiment, the package device 1150 is a microprocessor including an SRAM cache memory. As shown, device 1150 may employ a die or device having any transistor structures and/or related characteristics discussed herein. Packaged device 1150 may be further coupled to (e.g., communicatively coupled to) a board, a substrate, or an interposer 1160 along with, one or more of a power management integrated circuit (PMIC) 1130, RF (wireless) integrated circuit (RFIC) 1125 including a wideband RF (wireless) transmitter and/or receiver (TX/RX) (e.g., including a digital baseband and an analog front end module further comprises a power amplifier on a transmit path and a low noise amplifier on a receive path), and a controller 1135 thereof. In general, packaged device 1150 may be also be coupled to (e.g., communicatively coupled to) display screen 1105. As shown, one or both of PMIC 1130 and/or RFIC 1125 may employ a die or device having any transistor structures and/or related characteristics discussed herein.

Functionally, PMIC 1130 may perform battery power regulation, DC-to-DC conversion, etc., and so has an input coupled to battery 1115 and with an output providing a current supply to other functional modules. In an embodiment, PMIC 1130 may perform high voltage operations. As further illustrated, in the exemplary embodiment, RFIC 1125 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. In alternative implementations, each of these board-level modules may be integrated onto separate ICs coupled to the package substrate of packaged device 1150 or within a single IC (SoC) coupled to the package substrate of the packaged device 1150.

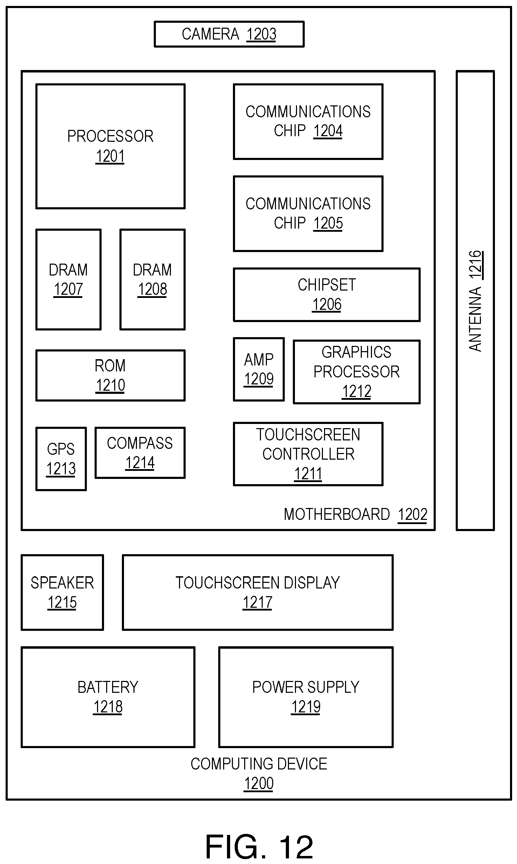

FIG. 12 is a functional block diagram of a computing device 1200, arranged in accordance with at least some implementations of the present disclosure. Computing device 1200 may be found inside platform 1200, for example, and further includes a motherboard 1102 hosting a number of components, such as but not limited to a processor 1201 (e.g., an applications processor) and one or more communications chips 1204, 1205. Processor 1201 may be physically and/or electrically coupled to motherboard 1202. In some examples, processor 1201 includes an integrated circuit die packaged within the processor 1201. In general, the term "processor" may refer to any device or portion of a device that processes electronic data from registers and/or memory to transform that electronic data into other electronic data that may be stored in registers and/or memory. Any one or more device or component of computing device 1200 may include a die or device having any transistor structures and/or related characteristics discussed herein as discussed herein.

In various examples, one or more communication chips 1204, 1205 may also be physically and/or electrically coupled to the motherboard 1202. In further implementations, communication chips 1204 may be part of processor 1201. Depending on its applications, computing device 1200 may include other components that may or may not be physically and electrically coupled to motherboard 1202. These other components may include, but are not limited to, volatile memory (e.g., DRAM) 1207, 1208, non-volatile memory (e.g., ROM) 1210, a graphics processor 1212, flash memory, global positioning system (GPS) device 1213, compass 1214, a chipset 1206, an antenna 1216, a power amplifier 1209, a touchscreen controller 1211, a touchscreen display 1217, a speaker 1215, a camera 1203, a battery 1218, and a power supply 1219, as illustrated, and other components such as a digital signal processor, a crypto processor, an audio codec, a video codec, an accelerometer, a gyroscope, and a mass storage device (such as hard disk drive, solid state drive (SSD), compact disk (CD), digital versatile disk (DVD), and so forth), or the like.

Communication chips 1204, 1205 may enable wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1204, 1205 may implement any of a number of wireless standards or protocols, including but not limited to those described elsewhere herein. As discussed, computing device 1200 may include a plurality of communication chips 1204, 1205. For example, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others. Furthermore, power supply 1219 may convert a source power from a source voltage to one or more voltages employed by other devices of mobile computing platform 1200. In some embodiments, power supply 1219 converts an AC power to DC power. In some embodiments, power supply 1219 converts an DC power to DC power at one or more different (lower) voltages. In some embodiments, multiple power supplies are staged to convert from AC to DC and then from DC at a higher voltage to DC at a lower voltage as specified by components of computing device 1200.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

In one or more first embodiments, a transistor structure comprises a channel semiconductor over a substrate and between a source and a drain, such that the source and the drain are epitaxial to the channel semiconductor, the channel semiconductor has a first lateral width along a lateral dimensional substantially perpendicular to an axis extending between the source and drain, one of the source or drain has a portion that extends beyond the lateral width of the channel semiconductor along the dimension by a second lateral width, and the second lateral width is not more than one-third of the first lateral width, a gate electrode coupled to the channel semiconductor, and a source contact coupled to the source and a drain contact coupled to the drain.

In one or more second embodiments, further to the first embodiment, the second lateral width is not more than one-quarter of the first lateral width.

In one or more third embodiments, further to the first or second embodiments, the one of the source or drain comprises a doped epitaxial nucleation layer on channel semiconductor and a doped epitaxial bulk layer on the doped epitaxial nucleation layer, the doped epitaxial nucleation layer comprising a lower dopant concentration than the doped epitaxial bulk layer.

In one or more fourth embodiments, further to any of the first through third embodiments, the doped epitaxial nucleation layer and the doped epitaxial bulk layer are doped with phosphorous and/or arsenic, and such that the one of the source or drain further comprises a phosphorous doped capping layer on the doped epitaxial bulk layer.

In one or more fifth embodiments, further to any of the first through fourth embodiments, the one of the source or drain comprises a first sidewall and a second sidewall opposite the first sidewall, such that any measurement between the first and second sidewalls along the lateral dimensional differ by not more than 8 nm.

In one or more sixth embodiments, further to any of the first through fifth embodiments, an aspect ratio of a height to a width of the one of the source or drain is not less than 2.

In one or more seventh embodiments, a system comprises a power supply and an integrated circuit die coupled to the power supply, the integrated circuit die comprising a transistor structure according to any of the first through sixth embodiments.

In one or more eighth embodiments, a method of fabricating a transistor structure comprises receiving a transistor structure comprising a channel semiconductor over a substrate, epitaxially depositing source and drain materials on the channel semiconductor, etching back the deposited source and drain materials via a gaseous chemical etch comprising chlorine and at least one of silane, phospane, or germane at a temperature in the range of 500°C to 800°C to provide a horizontal etch of the deposited source and drain materials at a faster rate than a vertical etch of the deposited source and drain materials, coupling a gate electrode to the channel semiconductor, and coupling a source contact and a drain contact to the source and drain materials.

In one or more ninth embodiments, further to the eighth embodiment, the method further comprises epitaxially depositing, subsequent to said etching back the deposited source and drain materials, second source and drain materials on the etched source and drain materials and etching back the deposited second source and drain materials via a second gaseous chemical etch comprising chlorine and at least one of silane, phospane, or germane.

In one or more tenth embodiments, further to the eighth or ninth embodiments, the source and drain materials comprise a doped epitaxial nucleation layer and the second source and drain materials comprise a doped epitaxial bulk layer, the doped epitaxial nucleation layer comprising a lower dopant concentration than the subsequent doped epitaxial bulk layer.

In one or more eleventh embodiments, further to any of the eighth through tenth embodiments, said epitaxially depositing the source and drain materials and said etching back the deposited source and drain materials are performed in a common processing chamber.

In one or more twelfth embodiments, further to any of the eighth through eleventh embodiments, said epitaxially depositing the source and drain materials comprises, prior to said etching back, depositing a doped epitaxial nucleation layer and a doped epitaxial bulk layer, the epitaxial nucleation layer comprising a lower dopant concentration than the subsequent epitaxial bulk layer.

In one or more thirteenth embodiments, further to any of the eighth through twelfth embodiments, the doped epitaxial nucleation layer and the doped epitaxial bulk layer are doped with phosphorous and/or arsenic, and where such that in said epitaxially depositing the source and drain materials further comprises, prior to said etching back, depositing a phosphorous doped capping layer on the doped epitaxial bulk layer.

In one or more fourteenth embodiments, further to any of the eighth through thirteenth embodiments, the gaseous chemical etch comprises germane at a temperature of not more than 650°C.

In one or more fifteenth embodiments, further to any of the eighth through fourteenth embodiments, the gaseous chemical etch comprises silane and phospane absent germane at a temperature of not less than 700°C.

In one or more sixteenth embodiments, further to any of the eighth through fifteenth embodiments, the deposited source material comprises a first lateral width variance and the etched source material comprises a second lateral width variance less than the first lateral width variance.

In one or more seventeenth embodiments, further to any of the eighth through sixteenth embodiments, the gaseous chemical etch comprises a first gas flow of hydrogen chloride and a second gas flow of hydrides comprising one or more of silane, phospane, or germane, and such that a ratio of the first gas flow to the second gas flow is in the range of 1 to 10.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. A transistor structure comprising:
a channel semiconductor over a substrate and between a source and a drain, wherein the source and the drain are epitaxial to the channel semiconductor, the channel semiconductor has a first lateral width along a lateral dimensional substantially perpendicular to an axis extending between the source and drain, one of the source or drain has a portion that extends beyond the lateral width of the channel semiconductor along the dimension by a second lateral width, and the second lateral width is not more than one-third of the first lateral width;
a gate electrode coupled to the channel semiconductor; and
a source contact coupled to the source and a drain contact coupled to the drain.

2. The transistor structure of claim 1, wherein the second lateral width is not more than one-quarter of the first lateral width.

3. The transistor structure of claim 1 or 2, wherein the one of the source or drain comprises a doped epitaxial nucleation layer on channel semiconductor and a doped epitaxial bulk layer on the doped epitaxial nucleation layer, the doped epitaxial nucleation layer comprising a lower dopant concentration than the doped epitaxial bulk layer.

4. The transistor structure of claim 3, wherein the doped epitaxial nucleation layer and the doped epitaxial bulk layer are doped with phosphorous and/or arsenic, and wherein the one of the source or drain further comprises a phosphorous doped capping layer on the doped epitaxial bulk layer.

5. The transistor structure of any of claims 1 to 4, wherein the one of the source or drain comprises a first sidewall and a second sidewall opposite the first sidewall, wherein any measurement between the first and second sidewalls along the lateral dimensional differ by not more than 8 nm, and /or wherein an aspect ratio of a height to a width of the one of the source or drain is not less than 2.

6. A system comprising:
a power supply;
an integrated circuit die coupled to the power supply, the integrated circuit die comprising a transistor structure according to any of claims 1 to 5.

7. A method of fabricating a transistor structure comprising:
receiving a transistor structure comprising a channel semiconductor over a substrate;
epitaxially depositing source and drain materials on the channel semiconductor;
etching back the deposited source and drain materials via a gaseous chemical etch comprising chlorine and at least one of silane, phospane, or germane at a temperature in the range of 500°C to 800°C to provide a horizontal etch of the deposited source and drain materials at a faster rate than a vertical etch of the deposited source and drain materials;
coupling a gate electrode to the channel semiconductor; and
coupling a source contact and a drain contact to the source and drain materials.

8. The method of claim 7, further comprising:
epitaxially depositing, subsequent to said etching back the deposited source and drain materials, second source and drain materials on the etched source and drain materials; and
etching back the deposited second source and drain materials via a second gaseous chemical etch comprising chlorine and at least one of silane, phospane, or germane.

9. The method of claim 8, wherein the source and drain materials comprise a doped epitaxial nucleation layer and the second source and drain materials comprise a doped epitaxial bulk layer, the doped epitaxial nucleation layer comprising a lower dopant concentration than the subsequent doped epitaxial bulk layer.

10. The method of any of claims 7 to 9, wherein said epitaxially depositing the source and drain materials and said etching back the deposited source and drain materials are performed in a common processing chamber.

11. The method any of claims 7 to 10, wherein said epitaxially depositing the source and drain materials comprises, prior to said etching back, depositing a doped epitaxial nucleation layer and a doped epitaxial bulk layer, the epitaxial nucleation layer comprising a lower dopant concentration than the subsequent epitaxial bulk layer.

12. The method of claim 11, wherein the doped epitaxial nucleation layer and the doped epitaxial bulk layer are doped with phosphorous and/or arsenic, and wherein said epitaxially depositing the source and drain materials further comprises, prior to said etching back, depositing a phosphorous doped capping layer on the doped epitaxial bulk layer.

13. The method of any of claims 7 to 12, wherein the gaseous chemical etch comprises germane at a temperature of not more than 650°C.

14. The method of any of claims 7 to 12, wherein the gaseous chemical etch comprises silane and phospane absent germane at a temperature of not less than 700°C.

15. The method of any of claims 7 to 14, wherein the deposited source material comprises a first lateral width variance and the etched source material comprises a second lateral width variance less than the first lateral width variance.
